# EUROPEAN PATENT APPLICATION

(11) **EP 4 510 469 A1**
(43) Date of publication of application: **19.02.2025**
(21) Application number: 24192900.9
(22) Date of filing: 05.08.2024
(51) Int. Cl.: H04B 10/25

(54) **AUDIO SIGNAL TRANSMISSION DEVICE AND METHOD, AUDIO SIGNAL RECEPTION DEVICE AND METHOD, AND AUDIO SYSTEM**

(30) Priority: 11.08.2023 TW 112130385
(71) Applicant: Acon Optics Communications Inc., New Taipai City 231 (TW)
(72) Inventor: CHEN, Lung-Chang, 231 New Taipei City (TW)
(74) Representative: Viering, Jentschura & Partner mbB Patent- und Rechtsanwälte

(57) **Abstract**

An audio signal transmission device (100), an audio signal transmission method, an audio signal reception device (400, 500), an audio signal reception method, and an audio system are provided. The audio signal transmission method includes: receiving an audio signal and generating a low-noise buffer signal by a low-noise buffer element (101); converting the low-noise buffer signal into a digital signal by an analog-to-digital conversion element; serializing a digital signal to output one or more serialized digital signals by a serializer element (103); and converting the one or more the serialized digital signals into one or more optical signals by an optical interface transmission device (104). The audio signal reception method includes: receiving and converting one of the at least one optical signal and outputting an electrical signal by the optical interface reception device (401); and deserializing the electrical signal and outputting the deserialized digital signal by the deserializer element (402).

## Description

### FIELD OF THE INVENTION

The instant disclosure is related to a speaker system, particularly a speaker system that utilizes optical fibers for signal transmission.

### BACKGROUND

A speaker system known to the inventor realizes signal transmission through metal wires. However, expensive metal wires would have to be used if it is desired to reduce power consumption when a signal travels through a metal wire, and therefore the cost of the overall system is increased.

### SUMMARY OF THE INVENTION

In view of this, some embodiments of the instant disclosure provide an audio signal transmission device, an audio signal transmission method, an audio signal reception device, an audio signal reception method, and a speaker system in order to resolve current technical issues.

Some embodiments of the instant disclosure provide an audio signal transmission device. The audio signal transmission device comprises a low-noise buffer element, an analog-to-digital conversion element, a serializer element, and an optical interface transmission device. The low-noise buffer element is configured to receive an audio signal to generate a low-noise buffer signal. The analog-to-digital conversion element is configured to convert the low-noise buffer signal into a digital signal. The serializer element is configured to serialize the digital signal so as to output at least one serialized digital signal. The optical interface transmission device is configured to convert the at least one serialized digital signal into at least one optical signal.

Some embodiments of the instant disclosure provide an audio signal transmission method. The audio signal transmission method comprises: receiving an audio signal and generating a low-noise buffer signal by a low-noise buffer element; converting the low-noise buffer signal into a digital signal by an analog-to-digital conversion element; serializing the digital signal by a serializer element so as to output at least one serialized digital signal; and converting the at least one serialized digital signal into at least one optical signal by an optical interface transmission device.

Some embodiments of the instant disclosure provide an audio signal reception device. The audio signal reception device can cooperate with the aforementioned audio signal transmission device. The audio signal reception device comprises an optical interface reception device and a deserializer element. The optical interface reception device is configured to receive and convert one of the at least one optical signal and output an electrical signal. The deserializer element is configured to deserialize the electrical signal and output a deserialized digital signal.

Some embodiments of the instant disclosure provide an audio signal reception method. The audio signal reception method can cooperate with the aforementioned audio signal transmission method. The audio signal reception method comprises: receiving and converting one of the at least one optical signal and outputting an electrical signal by an optical interface reception device; and deserializing the electrical signal and outputting a deserialized digital signal by a deserializer element.

Some embodiments of the instant disclosure provide speaker system. The speaker system comprises an audio signal transmission device, at least one optical fiber device, and at least one audio signal reception device. The audio signal transmission device comprises: a low-noise buffer element configured to receive an audio signal and generate a low-noise buffer signal; an analog-to-digital conversion element configured to convert the low-noise buffer signal into a digital signal; a serializer element configured to serialize the digital signal so as to output at least one serialized digital signal; and an optical interface transmission device configured to convert the at least one serialized digital signal into at least one optical signal and transmit the at least one optical signal to the at least one optical fiber device. Each of the at least one audio signal reception device comprises: an optical interface reception device configured to receive from the at least one fiber optical device and convert one of the at least one optical signal so as to output an electrical signal; and a deserializer element configured to deserialize the electrical signal and output a deserialized digital signal.

As above, by integrating the low-noise buffer elements, the analog-to-digital conversion elements, the serializer elements, the optical interface transmission device, the optical interface reception device, and the deserializer device and by the optical fiber device to transmit optical signals, the audio signal transmission device, the audio signal transmission method, the audio signal reception device, the audio signal reception method, and the speaker system provided by some embodiments of the instant disclosure can reduce signal loss and increase transmission distance.

### BRIEF DESCRIPTION OF THE DRAWINGS

The instant disclosure will become more fully understood from the detailed description given herein below for illustration only, and thus not limitative of the instant disclosure, wherein:
Fig. 1 illustrates a block diagram of an audio signal transmission device system according to some embodiments of the instant disclosure;
Fig. 2 illustrates a block diagram of an audio signal transmission device system according to some embodiments of the instant disclosure;
Fig. 3A illustrates a block diagram of an audio signal transmission device system according to some embodiments of the instant disclosure;
Fig. 3B illustrates a block diagram of an audio signal transmission device system according to some embodiments of the instant disclosure;
Fig. 4 illustrates a block diagram of an audio signal reception device system according to some embodiments of the instant disclosure;
Fig. 5 illustrates a block diagram of an audio signal reception device system according to some embodiments of the instant disclosure;
Fig. 6 illustrates a block diagram of a speaker system according to some embodiments of the instant disclosure;
Fig. 7 illustrates a schematic view of a speaker structure according to some embodiments of the instant disclosure;
Fig. 8 illustrates a block diagram of a speaker system according to some embodiments of the instant disclosure;
Fig. 9 illustrates a schematic view of a speaker structure according to some embodiments of the instant disclosure;
Fig. 10A illustrates a schematic view showing an application of a speaker system according to some embodiments of the instant disclosure;
Fig. 10B illustrates a schematic view showing an application of a speaker system according to some embodiments of the instant disclosure;
Fig. 11 illustrates a schematic view showing an application of a speaker system according to some embodiments of the instant disclosure;
Fig. 12 illustrates a flow chart of an audio signal transmission method according to an embodiment of the instant disclosure;
Fig. 13 illustrates a flow chart of an audio signal transmission method according to an embodiment of the instant disclosure;
Fig. 14 illustrates a flow chart of an audio signal transmission method according to an embodiment of the instant disclosure;
Fig. 15 illustrates a flow chart of an audio signal transmission method according to an embodiment of the instant disclosure;
Fig. 16 illustrates a flow chart of an audio signal reception method according to an embodiment of the instant disclosure; and
Fig. 17 illustrates a flow chart of an audio signal reception method according to an embodiment of the instant disclosure.

### DETAILED DESCRIPTION

The foregoing and other technical contents, features, and effects of the instant disclosure can be clearly presented below in detailed description with reference to embodiments of the accompanying drawings. Thicknesses or sizes of the elements in the drawings illustrated in an exaggerated, omitted, or general manner are used to help a person skilled in the art to understand and read, and the size of each element is not the completely actual size and is not intended to limit restraint conditions under which the instant disclosure can be implemented and therefore have no technical significance. Any modification to the structure, change to the proportional relationship, or adjustment on the size without affecting the effects and the objectives that can be achieved by the instant disclosure should fall within the scope of the technical content disclosed by the instant disclosure. In all drawings, identical symbols are used to denote identical or similar elements. In the following detailed description, the term "connect" may refer to any means of direct or indirect connection.

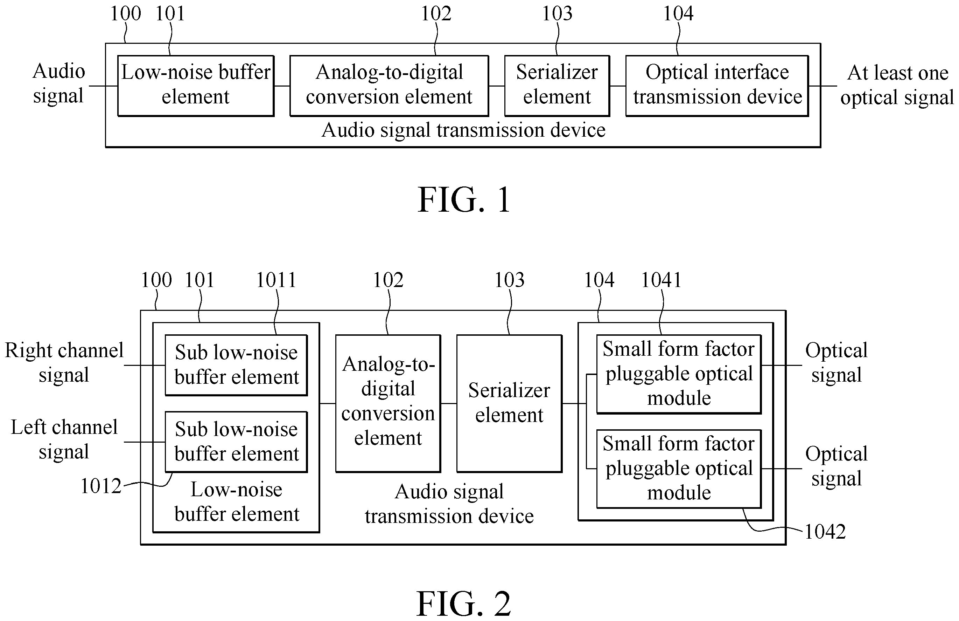

Fig. 1 illustrates a block diagram of an audio signal transmission device system according to some embodiments of the instant disclosure. Fig. 2 illustrates a block diagram of an audio signal transmission device system according to some embodiments of the instant disclosure. Please refer to Fig. 1 first. The audio signal transmission device 100 is adapted to receive an audio signal and output at least one corresponding optical signal. The audio signal transmission device 100 comprises a low-noise buffer element 101, an analog-to-digital conversion element 102, a serializer element 103, and an optical interface transmission device 104. The audio signal may comprise a plurality of sub audio signals. The sub audio signals may comprise a plurality of multichannel signals (such as left and right channel signals). The low-noise buffer element 101 is configured to lower a noise of the audio signal and generate a low-noise buffer signal. Lowering the noise of the audio signal can increase an accuracy of operation of the analog-to-digital conversion element 102. In some embodiments of the instant disclosure, the low-noise buffer element 101 comprises a second order low-pass filter for lowering the noise in the audio signal. Please refer to Fig. 2. In the embodiment illustrated in Fig. 2, the audio signal comprises a left channel signal and a right channel signal, and the low-noise buffer element 101 comprises a sub low-noise buffer element 1011 and a sub low-noise buffer element 1012. The sub low-noise buffer element 1011 is configured to lower the noise of the right channel signal and generate a right channel low-noise buffer signal. The sub low-noise buffer element 1012 is configured to lower the noise of the left channel signal and generate a left channel low-noise buffer signal. Therefore, in this embodiment, the low-noise buffer signal generated by the low-noise buffer element 101 comprises the right channel low-noise buffer signal and the left channel low-noise buffer signal. In this embodiment, the sub low-noise buffer element 1011 and the sub low-noise buffer element 1012 each comprise a second order low-pass filter so as to lower the noise of the audio signal.

Please refer to Fig. 1 again. The analog-to-digital conversion element 102 is configured to convert the low-noise buffer signal generated by the low-noise buffer element 101 into a digital signal. In some embodiments of the instant disclosure, the analog-to-digital conversion element 102 comprises an N-bit analog-to-digital converter with a sampling rate of M Hz so as to convert the low-noise buffer signal into an N-bit digital signal, where M is a positive real number, and N is a positive integer.

The analog-to-digital conversion element 102 may further comprise a control chip with an inter-IC sound (I²S) interface to process the digital signal after conversion. It is worth illustrating that, although the control chip with the I²S interface is adopted to process the digital signal after conversion in the foregoing embodiment, it is of course also possible to use a control chip with a time-division multiplexing (TDM) interface or a control chip with a pulse-code modulation (PCM) interface according to different demands, and the instant disclosure is not limited thereto.

Please refer to Fig. 2 again. In the embodiment shown in Fig. 2, the analog-to-digital conversion element 102 comprises an N-bit analog-to-digital converter with a sampling rate of M Hz. The N-bit analog-to-digital converter converts the right channel low-noise buffer signal and the left channel low-noise buffer signal. The analog-to-digital conversion element 102 processes the digital signal after conversion using the control chip with the I²S interface so as to integrate a left channel digital signal and a right channel digital signal after conversion (such as to integrate the left channel digital signal and the right channel digital signal after conversion into an I²S format). The analog-to-digital conversion element 102 then transmits the integrated signal to the serializer element 103.

It is worth illustrating that, in the embodiment shown in Fig. 2, the analog-to-digital conversion element 102 may comprise two N-bit analog-to-digital converters with sampling rates of M Hz so as to respectively convert the right channel low-noise buffer signal and the left channel low-noise buffer signal, and then the analog-to-digital conversion element 102 processes the digital signal after conversion using the control chip with the I²S interface so as to integrate the left channel digital signal and the right channel digital signal after conversion and transmits the integrated signal to the serializer element 103.

In some embodiments, the foregoing M is selected at 192k, and the foregoing N is selected at 24. In some embodiments, the foregoing M is selected at 384k, and the foregoing N is selected at 32. In some embodiments, the foregoing M is selected at 768k, and the foregoing N is selected at 32. It is worth illustrating that the values of M and N may be selected according to actual demands and are not limited to the values described in the foregoing embodiments.

In some embodiments, the analog-to-digital conversion element 102 comprises a multichannel analog-to-digital converter.

Please refer to Fig. 1 again. The serializer element 103 is configured to serialize a digital signal that is received so as to output at least one serialized digital signal. The serializer element 103 may comprise at least one serializer so as to output at least one serialized digital signal. The serializer mainly utilizes differential signal transmission technology and has the features of low power consumption, high interference immunity, and fast speed, and the highest transmission speed of the serial interface can theoretically reach above 10 Gbps.

Please refer to Fig. 2. In some embodiments of the instant disclosure, the serializer element 103 comprises a serializer. The serializer serializes the left channel digital signal and the right channel digital signal after conversion and integration (such as by integrating the left channel digital signal and the right channel digital signal after conversion into the I²S format) to obtain a serialized integrated digital signal. The serializer element 103 then outputs the serialized integrated digital signal to the optical interface transmission device 104.

Please refer to Fig. 2 again. In some embodiments of the instant disclosure, the serializer element 103 comprises a serializer. The serializer element 103 first divides the digital signal that is received into a left channel digital signal and the right channel digital signal. In some embodiments of the instant disclosure, the serializer element 103 comprises a left channel serializer and a right channel serializer so as to respectively serialize the left channel digital signal and the right channel digital signal. In the foregoing embodiment, the left channel digital signal after serialization and the right channel digital signal after serialization are the at least one serialized digital signal outputted by the serializer element 103.

Please refer to Fig. 1 and Fig. 2 at the same time. The optical interface transmission device 104 is configured to convert the at least one serialized digital signal into at least one optical signal. In some embodiments, as illustrated in Fig. 2, the optical interface transmission device 104 comprises a small form factor pluggable optical module (SFP optical module) 1041 and a small form factor pluggable optical module 1402. In this embodiment, the small form factor pluggable optical module 1041 and the small form factor pluggable optical module 1042 are small hot-pluggable optical transmitters for optical communication applications in telecommunication and data communication. Typical small form factor pluggable optical modules come in various transmission and reception types, and a user may choose a suitable small form factor pluggable optical module to perform data transmission on available optical fiber types (such as multimode fibers or single-mode fibers). It is worth illustrating that, although two small form factor pluggable optical modules 1041, 1042 are illustrated in Fig. 2, the optical interface transmission device 104 may of course comprise one or more small form factor pluggable optical modules 1041, 1042. The number of the small form factor pluggable optical modules is determined according to the number of required channels for data transmission, and the instant disclosure is not limited thereto.

In some embodiments of the instant disclosure, the small form factor pluggable optical module 1041 and the small form factor pluggable optical module 1042 simultaneously convert the serialized integrated digital signals into two optical signals.

In some embodiments of the instant disclosure, the small form factor pluggable optical module 1041 and the small form factor pluggable optical module 1042 respectively convert the left channel digital signal after serialization and the right channel digital signal after serialization into an optical signal corresponding to the left channel and an optical signal corresponding to the right channel.

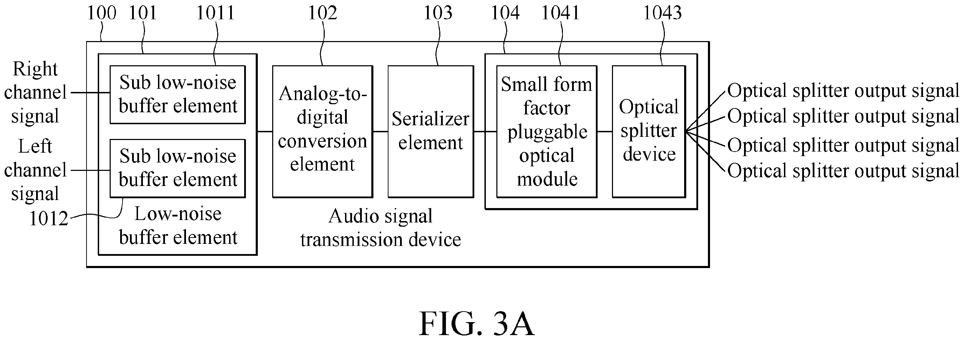

Fig. 3A illustrates a block diagram of an audio signal transmission device system according to some embodiments of the instant disclosure. Please refer to Fig. 1, Fig. 2, and Fig. 3A at the same time. Comparing Fig. 3A with Fig. 2, Fig. 3A includes one small form factor pluggable optical module 1041 and further includes an optical splitter device 1043 to split the outputs of the small form factor pluggable optical module 1041 into a plurality of optical splitter output signals. In some embodiments of the instant disclosure, the serializer element 103 outputs the aforementioned serialized integrated digital signal to the optical interface transmission device 104, the small form factor pluggable optical module 1041 converts the aforementioned serialized integrated digital signal into the optical signal, and the optical splitter device 1043 then splits the output of the small form factor pluggable optical module 1041 into a plurality of optical splitter output signals. At this time, each of the optical splitter output signals comprises information of the aforementioned serialized integrated digital signal. After different audio signal reception devices respectively receive the aforementioned optical splitter output signals, the audio signal reception devices then extract the left channel digital signal and the right channel digital signal based on the optical splitter output signals that are received and according to demands.

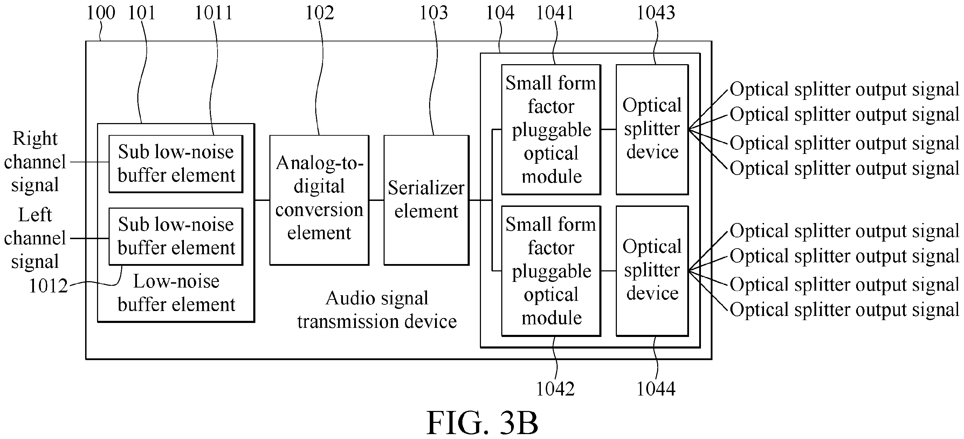

Fig. 3B illustrates a block diagram of an audio signal transmission device system according to some embodiments of the instant disclosure. Please refer to Fig. 1, Fig. 2, and Fig. 3 at the same time. Comparing Fig. 3B with Fig. 2, Fig. 3B further includes an optical splitter device 1043 and an optical splitter device 1044 so as to respectively split the output of the small form factor pluggable optical module 1041 and the output of the small form factor pluggable optical module 1042 into a plurality of optical splitter output signals.

It is worth illustrating that the optical splitter device 1043 and the optical splitter device 1044 may be selected according to demands as fused biconical taper optical splitters or planar waveguide type optical splitters, and the instant disclosure is not limited thereto.

It is also worth illustrating that, although the audio signal includes the left channel signal and the right channel signal in the embodiment shown in Fig. 2, Fig. 3A, and Fig. 3B, the audio signal may comprise a multi-channel signal with more channels according to different demands, or the audio signal may merely comprise a single-channel signal, and the instant disclosure is not limited thereto.

The following paragraphs will illustrate with the accompanying drawings the audio signal transmission method and how the modules of the audio signal transmission device 100 cooperate with each other according to some embodiments of the instant disclosure.

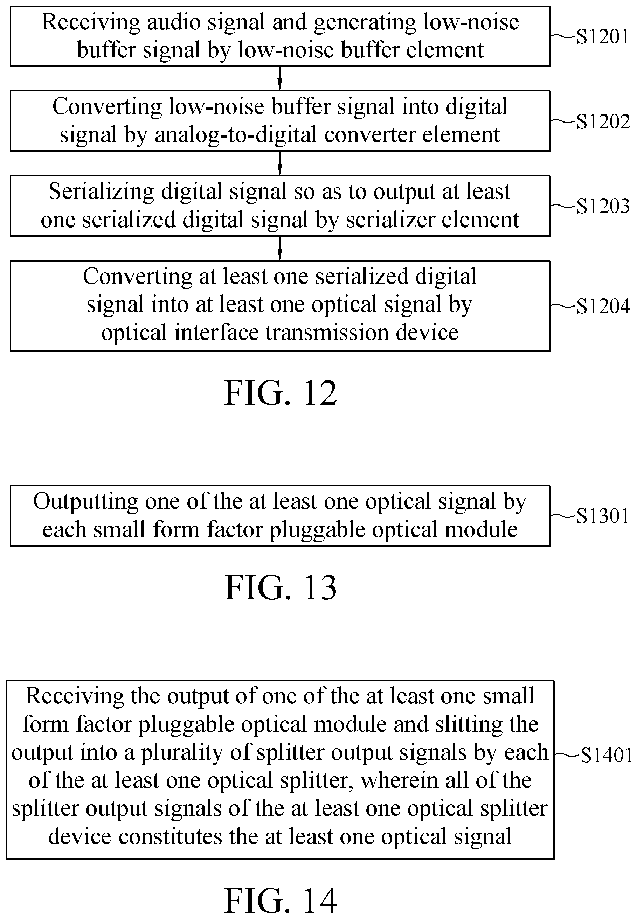

Fig. 12 illustrates a flow chart of an audio signal transmission method according to an embodiment of the instant disclosure. Please refer to Fig. 1 and Fig. 12 at the same time. In the embodiment shown in Fig. 12, the audio signal transmission method comprises the step S1201 through the step S1204. In the step S1201, the low-noise buffer element 101 receives the audio signal and generates the low-noise buffer signal. In the step S1202, the analog-to-digital conversion element 102 converts the low-noise buffer signal into the digital signal. In the step S1203, the serializer element 103 serializes the digital signal so as to output at least one serialized digital signal. In the step S1204, the optical interface transmission device 104 converts the at least one serialized digital signal into at least one optical signal.

Fig. 13 illustrates a flow chart of an audio signal transmission method according to an embodiment of the instant disclosure. Please refer to Fig. 1, Fig. 2, and Fig. 13 at the same time. In some embodiments of the instant disclosure, the optical interface transmission device 104 comprises at least one small form factor pluggable optical module (such as the small form factor pluggable optical modules 1041, 1042 illustrated in Fig. 2), and the step S1204 comprises a step S1301. In the step S1301, each of the small form factor pluggable optical modules outputs one of the at least one optical signal (i.e., a corresponding optical signal).

Fig. 14 illustrates a flow chart of an audio signal transmission method according to an embodiment of the instant disclosure. Please refer to Fig. 1, Fig. 3B, and Fig. 14 at the same time. In some embodiments of the instant disclosure, the optical interface transmission device 104 comprises at least one small form factor pluggable optical module (such as the small form factor pluggable optical modules 1041, 1042 illustrated in Fig. 3B) and at least one optical splitter device (such as the optical splitter devices 1043, 1044). In these embodiments, each of the optical splitter devices receives the output of one of the aforementioned at least one small form factor pluggable optical module (i.e., the output of a corresponding small form factor pluggable optical module). Further, in these embodiments, the step S1204 comprises a step S1401. In the step S1401, each of the optical splitters receives the output of one of the at least one small form factor pluggable optical module and splits the output into a plurality of optical splitter output signals, where all of the optical splitter output signals of the aforementioned at least one optical splitter constitute the aforementioned at least one optical signal.

It is worth illustrating that, in the aforementioned embodiment, because the power consumption of using the optical splitter device to split the optical signal into a plurality of optical splitter output signals and output and transmit the optical splitter output signals is less than the power consumption of generating and transmitting a plurality of electrical signals, the power consumption for the operation of the overall system can be decreased.

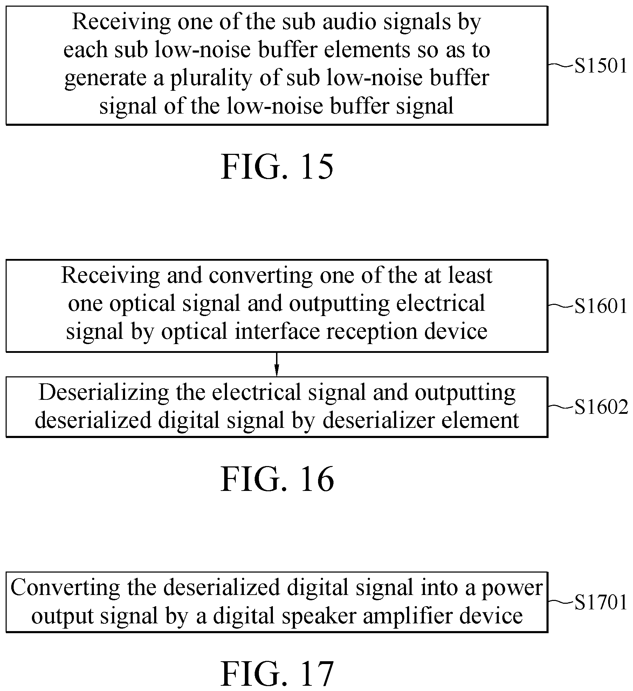

Fig. 15 illustrates a flow chart of an audio signal transmission method according to an embodiment of the instant disclosure. Please refer to Fig. 1, Fig. 3A, Fig. 3B, and Fig. 15 at the same time. In some embodiments of the instant disclosure, the audio signal comprises a plurality of sub audio signals (such as the left channel signal and the right channel signal illustrated in Fig. 2, Fig. 3A and Fig. 3B), the low-noise buffer element 101 comprises a plurality of sub low-noise buffer elements (such as the sub low-noise buffer element 1011 and the sub low-noise buffer element 1012 illustrated in Fig. 2 and Fig. 3), and the step S1201 comprises a step S1501. In the step S1501, each of the sub low-noise buffer elements (such as the sub low-noise buffer element 1011 and the sub low-noise buffer element 1012 illustrated in Fig. 2 and Fig. 3) receives a corresponding one of the sub audio signals (such as the left channel signal and the right channel signal illustrated in Fig. 2, Fig. 3A and Fig. 3B) (i.e., a corresponding sub audio signal) to generate a plurality of sub low-noise buffer signals of the low-noise buffer signal.

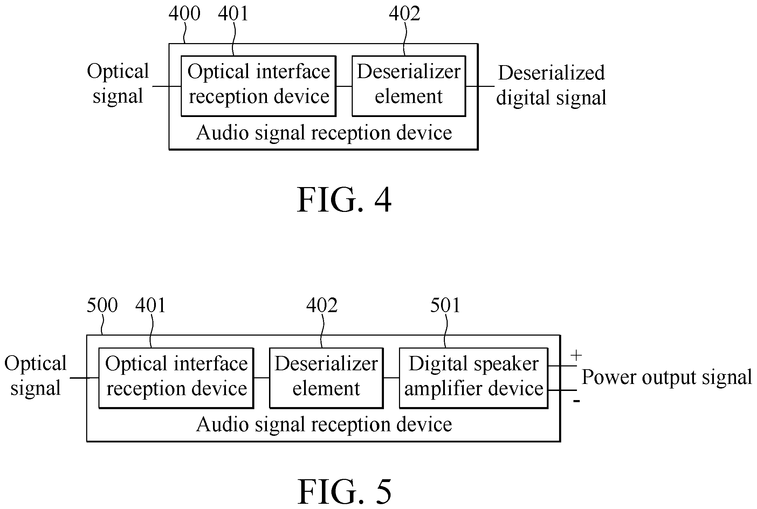

Fig. 4 illustrates a block diagram of an audio signal reception device system according to some embodiments of the instant disclosure. Please refer to Fig. 4. The audio signal reception device 400 is adapted to receive one of the at least one optical signal (i.e., a corresponding optical signal) outputted by the aforementioned audio signal transmission device 100 and generate a deserialized digital signal corresponding to the received optical signal. The audio signal reception device 400 comprises an optical interface reception device 401 and a deserializer element 402. The optical interface reception device 401 is configured to receive and convert one of the at least one optical signal and output an electrical signal. In some embodiments of the instant disclosure, in correspondence with the embodiments shown in Fig. 2, Fig. 3A, and Fig. 3B, the optical interface reception device 401 comprises a small form factor pluggable optical module so as to receive one of the at least one optical signal, convert the received optical signal, and output an electrical signal. The electrical signal corresponds to one of the at least one serialized digital signal outputted by the serializer element 103. The deserializer element 402 is configured in correspondence with the serializer element 103 in Fig. 1 and is able to deserialize a signal which was serialized by the serializer element 103. The deserializer element 402 is configured to deserialize the electrical signal outputted by the optical interface reception device 401 and output the deserialized digital signal.

Please refer to Fig. 2 and Fig. 4 at the same time. Continuing from the aforementioned embodiment where the serializer serializes the left channel digital signal and the right channel digital signal after conversion and integration into a serialized integrated digital signal, in this embodiment, whether the audio signal reception device 400 receives the optical signal outputted by the small form factor pluggable optical module 1401 of Fig. 2 or the small form factor pluggable optical module 1402, the electrical signal outputted by the small form factor pluggable optical module of the optical interface reception device 401 always corresponds to the serialized integrated digital signal. The deserializer element 402 deserializes the electrical signal outputted by the optical interface reception device 401 to obtain the deserialized digital signal which corresponds to the aforementioned digital signal of the left channel digital signal and the right channel digital signal after conversion and integration.

Please refer to Fig. 2 and Fig. 4 at the same time again. Continuing from the aforementioned embodiment where the serializers respectively serialize the left channel digital signal and the right channel digital signal, if the audio signal reception device 400 receives the optical signal outputted by the small form factor pluggable optical module 1401, then the electrical signal outputted by the small form factor pluggable optical module of the optical interface reception device 401 will correspond to the right channel digital signal which has been serialized, and the deserialized digital signal outputted by the deserializer element 402 will correspond to the right channel digital signal.

Please refer to Fig. 3A and Fig. 4 at the same time. Taking the embodiment illustrated in Fig. 3A for example, if the audio signal reception device 400 receives the optical signal outputted by the optical splitter device 1043 of Fig. 3A, then the electrical signal of the small form factor pluggable optical module of the optical interface reception device 401 will correspond to the serialized integrated digital signal.

Fig. 16 illustrates a flow chart of an audio signal reception method according to an embodiment of the instant disclosure. Please refer to Fig. 4 and Fig. 16 at the same time. The audio signal reception method illustrated in Fig. 16 may be used along with the audio signal transmission method illustrated in Fig. 12 through Fig. 15. In the embodiment shown in Fig. 16, the audio signal reception method comprises the step S1601 through the step S1602. In the step S1601, the optical interface reception device 401 receives one of the at least one optical signal, converts the received optical signal, and outputs the electrical signal. In the step S1602, the deserializer element 402 deserializes the electrical signal and outputs the deserialized digital signal.

Fig. 5 illustrates a block diagram of an audio signal reception device system according to some embodiments of the instant disclosure. Please refer to Fig. 5. Compared with the audio signal reception device 400 illustrated in Fig. 4, the audio signal reception device 500 further comprises a digital speaker amplifier device 501. The digital speaker amplifier device 501 is configured to convert the deserialized digital signal into a power output signal. The "+" symbol and the "-" symbol illustrated in Fig. 5 represent the anode and cathode of the power output signal, respectively. In this embodiment, the step of converting the deserialized digital signal into the power output signal comprises: (1) selecting a component to be outputted from the deserialized digital signal; and (2) amplifying the component to be outputted from the deserialized digital signal so that the power output signal reaches a level that is high enough to drive a speaker or a pair of earphones. In some embodiments of the instant disclosure, the digital speaker amplifier device 501 comprises a digital speaker amplifier circuit so as to amplify the deserialized digital signal.

Taking the aforementioned embodiment where the serializer serializes the left channel digital signal and the right channel digital signal after conversion and integration into a serialized integrated digital signal for example, if the digital speaker amplifier device 501 is to output the right channel signal, then the digital speaker amplifier device 501 will first extract the right channel digital signal from the deserialized digital signal (which corresponds to the left channel digital signal and the right channel digital signal after conversion and integration ) and then amplify the extracted signal as the power output signal.

Taking the aforementioned embodiment where the serializers respectively serialize the left channel digital signal and the right channel digital signal for example, if the digital speaker amplifier device 501 is to output the right channel signal, then the audio signal reception device 400 will be configured to receive the optical signal which corresponds to the right channel. In this case, the digital speaker amplifier device 501 will amplify all deserialized digital signal (i.e., select all of the deserialized digital signals as components to be outputted) as the power output signal.

Fig. 17 illustrates a flow chart of an audio signal reception method according to an embodiment of the instant disclosure. Please refer to Fig. 5, Fig. 16, and Fig. 17 at the same time. In the embodiment illustrated in Fig. 17, after the step S1602, the step S1701 is further executed. In the step S1701, the digital speaker amplifier device 501 converts the deserialized digital into the power output signal.

In this embodiment, instead of converting the deserialized digital signal into an analog signal before driving the speaker or the earphones, the digital speaker amplifier device 501 is used to directly convert the deserialized digital into the power output signal so as to directly drive the speaker or the earphones. As a result, the number of junctions can be decreased to decrease signal loss.

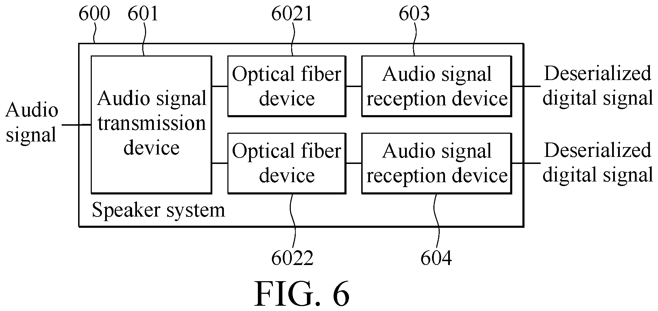

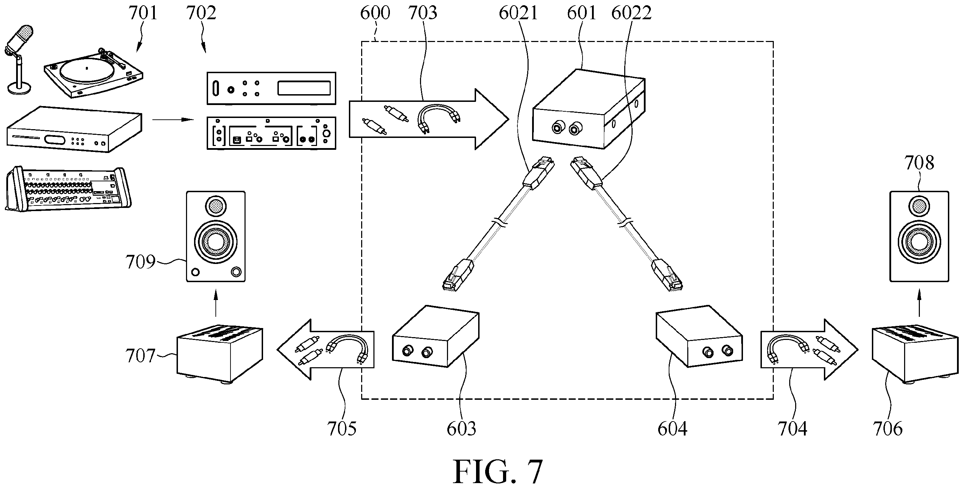

Fig. 6 illustrates a block diagram of a speaker system according to some embodiments of the instant disclosure. Fig. 7 illustrates a schematic view of a speaker structure according to some embodiments of the instant disclosure. Please first refer to Fig. 6. The speaker system 600 comprises an audio signal transmission device 601, an optical fiber device 6021, an optical fiber device 6022, an audio signal reception device 603, and an audio signal reception device 604. The audio signal transmission device 601 may adopt an audio signal transmission device of the aforementioned embodiments (such as the audio signal transmission device 100 illustrated in Fig. 1 through Fig. 3A and Fig. 3B). The audio signal reception device 603 and the audio signal reception device 604 adopt the audio signal reception device 400 described in the aforementioned embodiment of Fig. 4. The optical fiber device 6021 and the optical fiber device 6022 may adopt multimode fibers or single-mode fibers, and the instant disclosure is not limited thereto.

Please refer to Fig. 6 and Fig. 7 at the same time. In the embodiment shown in Fig. 7, a signal generated by a sound source 701 is converted by a preamplifier 702 into an audio signal to be inputted to the audio signal transmission device 601. The aforementioned audio signal comprises a left channel signal and a right channel signal and is transmitted by a transmission cable 703 to the audio signal transmission device 601. The left channel signal and the right channel signal are converted by the audio signal transmission device 601 into two optical signals which correspond to the serialized integrated digital signal. The two optical signals are respectively transmitted to the audio signal reception device 603 and the audio signal reception device 604. The audio signal reception device 603 and the audio signal reception device 604 respectively output the deserialized digital signals. The deserialized digital signals are respectively transmitted through a transmission cable 704 and a transmission cable 705 to a digital speaker amplifier device 706 and a digital speaker amplifier device 707, and the deserialized digital signals are converted to power output signals.

The power output signal of the digital speaker amplifier device 706 and the power output signal of the digital speaker amplifier device 707 respectively drive the right speaker device 708 and the left speaker device 709. In this embodiment, the transmission cable 703, the transmission cable 704, and the transmission cable 705 may be RCA cables.

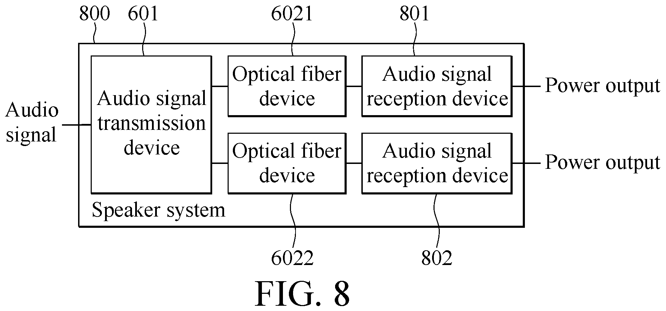

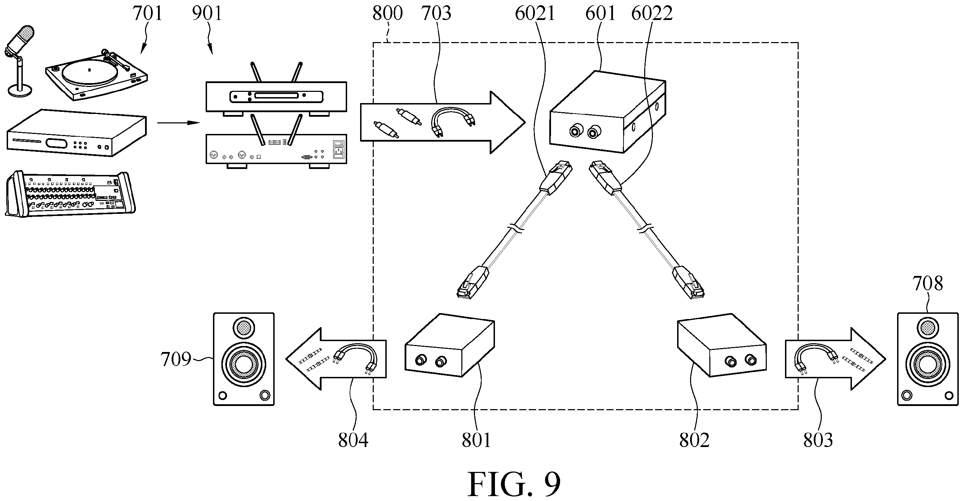

Fig. 8 illustrates a block diagram of a speaker system according to some embodiments of the instant disclosure. Fig. 9 illustrates a schematic view of a speaker structure according to some embodiments of the instant disclosure. Please refer to Fig. 8 first. Compared with the embodiment illustrated in Fig. 7, the audio signal reception device 801 and the audio signal reception device 802 in the speaker system of Fig. 8 adopt the audio signal reception device 500 described in the aforementioned embodiment of Fig. 5. In other words, in this embodiment, the digital speaker amplifier device 501 is provided in each of the audio signal reception device 801 and the audio signal reception device 802.

Please refer to Fig. 8 and Fig. 9 at the same time. In the embodiment shown in Fig. 9, compared with the embodiment illustrated in Fig. 7, the signal generated by the sound source 701 is converted by a preamplifier 901 into an audio signal to be inputted to the audio signal transmission device 601. The preamplifier 901 comprises a sound source switcher. The left channel signal and the right channel signal are converted by the audio signal transmission device 601 into two optical signals which correspond to the serialized integrated digital signal. The two optical signals are respectively transmitted to the audio signal reception device 801 and the audio signal reception device 802. The digital speaker amplifier device 501 of the audio signal reception device 801 and the digital speaker amplifier device 501 of the audio signal reception device 802 respectively output the power output signals. The power output signal of the digital speaker amplifier device 706 and the power output signal of the digital speaker amplifier device 707 are respectively transmitted through a transmission cable 803 and a transmission cable 803 to drive a right speaker device 708 and a left speaker device 709. In this embodiment, the transmission cable 803 and the transmission cable 804 may be speaker cables.

It is worth illustrating that, in the foregoing embodiment, the left channel signal and the right channel signal are converted by the audio signal transmission device 601 into two optical signals which correspond to the serialized integrated digital signal. The speaker systems 600, 800 may also respectively transmit the left channel signal and the right channel signal through the audio signal transmission device 601 to generate the optical signal which corresponds to the left channel signal and the optical signal which corresponds to the right channel signal. The optical signal which corresponds to the left channel signal is transmitted through an optical fiber device 6021 to the audio signal reception device 603. The optical signal which corresponds to the right channel signal is transmitted through an optical fiber device 6022 to the audio signal reception device 604.

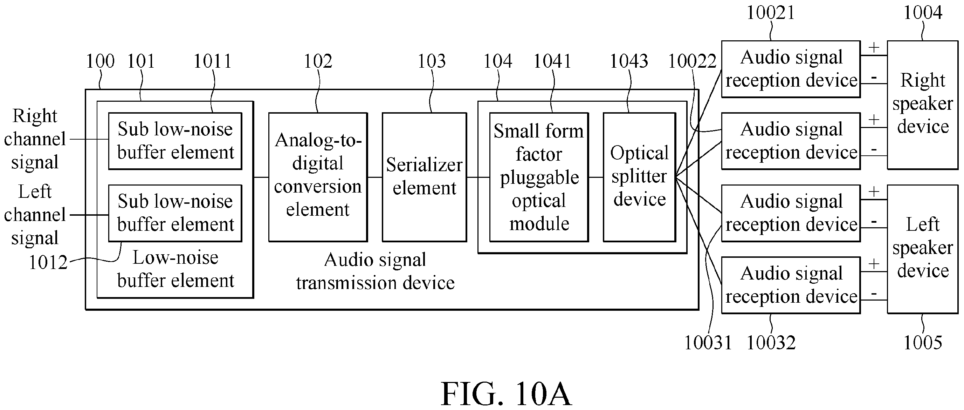

Fig. 10A illustrates a schematic view showing an application of a speaker system according to some embodiments of the instant disclosure. Please refer to Fig. 3A and Fig. 10A at the same time. In the embodiment illustrated in Fig. 10A, the audio signal comprises the left channel signal and the right channel signal. The left channel signal and the right channel signal are converted by the audio signal transmission device 100 into four optical signals which correspond to the serialized integrated digital signal. In this embodiment, audio signal reception devices 10021, 10022, 10031, 10032 adopt the audio signal reception device 500 described in the embodiment of Fig. 4. Two of the optical signals are transmitted to the audio signal reception devices 10021 and the audio signal reception devices 10022 which drive a right speaker device 1004. The other two of the optical signals are transmitted to the audio signal reception devices 10031 and the audio signal reception devices 10032 which drive a left speaker device 1005. The right speaker device 1004 and the left speaker device 1005 each have a treble (high frequencies) terminal and a bass (low frequencies) terminal. The power output signal of the audio signal reception devices 10021 is connected to the treble terminal of the right speaker device 1004. The power output signal of the audio signal reception devices 10022 is connected to the bass terminal of the right speaker device 1004. The power output signal of the audio signal reception devices 10031 is connected to the treble terminal of the left speaker device 1005. The power output signal of the audio signal reception devices 10032 is connected to the bass terminal of the left speaker device 1005. The "+" symbols and the "-" symbols illustrated in Fig. 10A represent the anodes and cathodes of the power output signals, respectively. In the foregoing embodiment, because the optical interface transmission device 104 is used to first convert the electrical digital into the optical signal, the optical splitter devices 1043 can be used to split a signal into a plurality of signals and respectively transmit the plurality of signals to the audio signal reception devices 10021, 10022, 10031, 10032 with low power consumption. Besides, because the optical fiber devices are used to transmit the optical signals, signal loss can be decreased, and transmission distance can be increased.

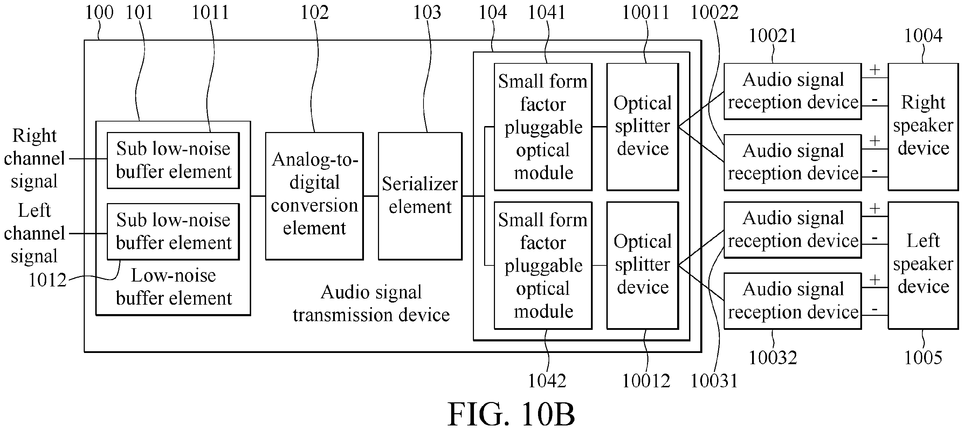

Fig. 10B illustrates a schematic view showing an application of a speaker system according to some embodiments of the instant disclosure. Please refer to Fig. 3B and Fig. 10B at the same time. In the embodiment illustrated in Fig. 10B, two optical signals which correspond to the left channel and two optical signals which correspond to the right channel are respectively generated (by an optical splitter device 10012 and an optical splitter device 10011, respectively). The two optical signals which correspond to the left channel are transmitted to the audio signal reception device 10031 and the audio signal reception device 10032 of the left speaker device 1005. The two optical signals which correspond to the right channel are transmitted to the audio signal reception device 10021 and the audio signal reception device 10022 of the right speaker device 1004.

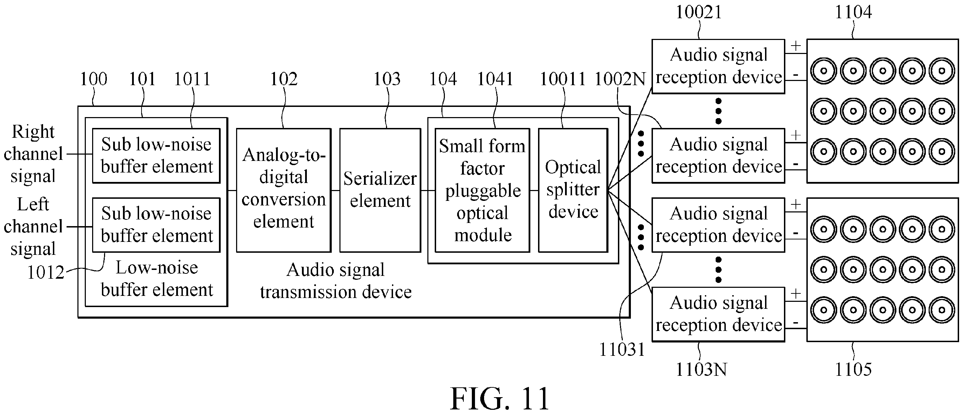

Fig. 11 illustrates a schematic view showing an application of a speaker system according to some embodiments of the instant disclosure. Please refer to Fig. 10A and Fig. 11 at the same time. Compared with the embodiment illustrated in Fig. 10A, the left channel signal and the right channel signal are converted by the audio signal transmission device 100 into a plurality of optical signals (generated by an optical splitter device 11011) which correspond to the serialized integrated digital signal. Some of the plurality of optical signals are transmitted to audio signal reception devices 11021-1102N which drive a right array speaker device 1104, and rest of the plurality of optical signals are transmitted to audio signal reception devices 11031-1103N which drive a left array speaker device 1105, where N is a positive integer.

As above, by integrating the low-noise buffer elements, the analog-to-digital conversion elements, the serializer elements, the optical interface transmission device, the optical interface reception device, and the deserializer device and by the optical fiber device to transmit optical signals, the audio signal transmission device, the audio signal transmission method, the audio signal reception device, the audio signal reception method, and the speaker system provided by some embodiments of the instant disclosure can reduce signal loss and increase transmission distance.

## Claims

1. An audio signal transmission device (100, 601) comprising:
a low-noise buffer element (101) configured to receive an audio signal and generate a low-noise buffer signal;
an analog-to-digital conversion element (102) configured to convert the low-noise buffer signal into a digital signal;
a serializer element (103) configured to serialize the digital signal so as to output at least one serialized digital signal; and
an optical interface transmission device (104) configured to convert the at least one serialized digital signal into at least one optical signal.

2. The audio signal transmission device (100, 601) according to claim 1, wherein the optical interface transmission device (104) comprises at least one small form factor pluggable optical module (1041, 1042), and each of the at least one small form factor pluggable optical module (1041, 1042) outputs one of the at least one optical signal.

3. The audio signal transmission device (100, 601) according to claim 1, wherein the optical interface transmission device (104) comprises at least one small form factor pluggable optical module (1041, 1042) and at least one optical splitter device (1043, 1044), each of the at least one optical splitter device (1043, 1044) receives an output of one of the at least one small form factor pluggable optical module (1041, 1042) and splits the output into a plurality of optical splitter output signals, and all of the optical splitter output signals of the at least one optical splitter device (1043, 1044) constitutes the at least one optical signal.

4. The audio signal transmission device (100, 601) according to claim 1, wherein the audio signal comprises a plurality of sub audio signals, the low-noise buffer element (101) comprises a plurality of sub low-noise buffer elements (1011, 1012), each of the sub low-noise buffer elements (1011, 1012) receives a corresponding one of the sub audio signals so as to generate a plurality of sub low-noise buffer signals of the low-noise buffer signal.

5. The audio signal transmission device (100, 601) according to claim 4, wherein the sub audio signals comprise a plurality of multichannel signals.

6. The audio signal transmission device (100, 601) according to claim 1, wherein the analog-to-digital conversion element (102) comprises a multichannel analog-to-digital converter.

7. An audio signal reception device (400, 500, 603, 604, 801, 802, 10021-1002N, 10031-1003N) in cooperation with the audio signal transmission devices (100, 601) according to any one of claims 1-6, wherein the audio signal reception device (400, 500) comprises:
an optical interface reception device (401) configured to receive and convert one of the at least one optical signal and output an electrical signal; and
a deserializer element (402) configured to deserialize the electrical signal and output a deserialized digital signal.

8. The audio signal reception device (400, 500) according to claim 7, wherein the audio signal reception device (400, 500) comprises:
a digital speaker amplifier device (501) configured to convert the deserialized digital signal into a power output signal.

9. An audio signal transmission method comprising:
receiving an audio signal and generating a low-noise buffer signal by a low-noise buffer element (101);
converting the low-noise buffer signal into a digital signal by an analog-to-digital conversion element;
serializing the digital signal so as to output at least one serialized digital signal by a serializer element (103); and
converting the at least one serialized digital signal into at least one optical signal by an optical interface transmission device (104).

10. The audio signal transmission method according to claim 9, wherein the optical interface transmission device (104) comprises at least one small form factor pluggable optical module (1041, 1042), and the audio signal transmission method comprises:
outputting one of the at least one optical signal by each of the at least one small form factor pluggable optical module (1041, 1042).

11. The audio signal transmission method according to claim 9, wherein the optical interface transmission device (104) comprises at least one small form factor pluggable optical module (1041, 1042) and at least one optical splitter device, each of the at least one optical splitter device receives an output of one of the at least one small form factor pluggable optical module (1041, 1042), and the audio signal transmission method comprises:
receiving an output of one of the at least one small form factor pluggable optical module (1041, 1042) and slitting the output into a plurality of splitter output signals by each of the at least one optical splitter, wherein all of the splitter output signals of the at least one optical splitter device constitutes the at least one optical signal.

12. The audio signal transmission method according to claim 9, wherein the audio signal comprises a plurality of sub audio signals, the low-noise buffer element (101) comprises a plurality of sub low-noise buffer elements (1011, 1012), and the audio signal transmission method comprises:
receiving one of the sub audio signals by each of the sub low-noise buffer elements (1011, 1012) so as to generate a plurality of sub low-noise buffer signal of the low-noise buffer signal.

13. The audio signal transmission method according to claim 12, wherein the sub audio signals comprise a plurality of multichannel signals.

14. The audio signal transmission method according to claim 9, wherein the analog-to-digital conversion element (102) comprises a multichannel analog-to-digital converter.

15. An audio signal reception method in cooperation with the audio signal transmission method according to any one of claims 9-14, wherein the audio signal reception method comprises:
receiving and converting one of the at least one optical signal and outputting an electrical signal by an optical interface reception device (401); and
deserializing the electrical signal and outputting a deserialized digital signal by a deserializer element (402).

16. The audio signal reception method according to claim 15, wherein the audio signal reception method further comprises:
converting the deserialized digital signal into a power output signal by a digital speaker amplifier device (501).

17. A speaker system (600, 800) comprising:
an audio signal transmission device (100, 601), at least one optical fiber device (6021, 6022), and at least one audio signal reception device (400, 500, 603, 604, 801, 802, 10021-1002N, 10031-1003N), wherein,
the audio signal transmission device (100, 601) comprises: a low-noise buffer element (101) configured to receive an audio signal and generate a low-noise buffer signal; an analog-to-digital conversion element (102) configured to convert the low-noise buffer signal into a digital signal; a serializer element (103) configured to serialize the digital signal so as to output at least one serialized digital signal; and an optical interface transmission device (104) configured to convert the at least one serialized digital signal into at least one optical signal and transmit the at least one optical signal to the at least one optical fiber device;
the at least one audio signal reception device (400, 500, 603, 604, 801, 802, 10021-1002N, 10031-1003N) comprises: an optical interface reception device (401) configured to receive from the at least one fiber optical device and convert one of the at least one optical signal so as to output an electrical signal; and a deserializer element (402) configured to deserialize the electrical signal and output a deserialized digital signal.

18. The speaker system (600, 800) according to claim 17, wherein the audio signal comprises a plurality of multichannel signals; the low-noise buffer element (101) comprises a plurality of sub low-noise buffer elements (1011, 1012), each of the sub low-noise buffer elements (1011, 1012) receives a corresponding one of the multichannel signals so as to generate a plurality of sub low-noise buffer signals of the low-noise buffer signal, and each of the at least one serialized digital signal corresponds to one of the multichannel signals.

19. The speaker system (600, 800) according to claim 17, wherein the optical interface transmission device (104) comprises at least one small form factor pluggable optical module (1041, 1042), and each of the at least one small form factor pluggable optical module (1041, 1042) outputs one of the at least one optical signal.

20. The speaker system (600, 800) according to claim 17, wherein the optical interface transmission device (104) comprises at least one small form factor pluggable optical module (1041, 1042) and at least one optical splitter device (1043, 1044), each of the at least one optical splitter device (1043, 1044) receives an output of one of the at least one small form factor pluggable optical module (1041, 1042) and splits the output into a plurality of splitter output signals, and all of the splitter output signals of the at least one optical splitter device (1043, 1044) constitutes the at least one optical signal.

21. The speaker system (600, 800) according to claim 17, wherein each of the at least one the audio signal reception device (400, 500) comprises: a digital speaker amplifier device (501) configured to convert the deserialized digital signal into a power output signal.

22. The speaker system (600, 800) according to claim 21, wherein the speaker system (600, 800) comprises at least one speaker device (1004, 1005), and each of the at least one speaker device (1004, 1005) receives the power output signal of one of the at least one audio signal reception device (400, 500, 603, 604, 801, 802, 10021-1002N, 10031-1003N) so as to play a corresponding sound.

23. The speaker system (600, 800) according to claim 21, wherein the speaker system (600, 800) comprises an array speaker device (1104, 1105), and the array speaker device (1104, 1105) receives the power output signal of each of the at least one audio signal reception device (400, 500, 603, 604, 801, 802, 10021-1002N, 10031-1003N) so as to play a corresponding sound.
